# EUROPEAN PATENT APPLICATION

(11) **EP 4 593 014 A1**
(43) Date of publication of application: **30.07.2025**
(21) Application number: 24801815.2
(22) Date of filing: 11.09.2024
(51) Int. Cl.: G11C 11/4076

(54) **COMMAND TIMING CONTROL CIRCUIT AND MEMORY**

(30) Priority: 30.11.2023 CN 202311659153
(71) Applicant: CXMT Corporation, Hefei, Anhui 230601 (CN)
(72) Inventor: DU, Wenxue, Hefei, Anhui 230601 (CN); SHI, Yangjie, Hefei, Anhui 230601 (CN); DAI, Kai, Hefei, Anhui 230601 (CN)
(74) Representative: Gulde & Partner
(86) International application number: PCT/CN2024/118225
(87) International publication number: WO 2025/112795

(57) **Abstract**

Embodiments of the present disclosure provide a command timing control circuit and a memory. The command timing control circuit includes a decoding circuit and a shift circuit, where the decoding circuit is configured to perform decoding processing according to a frequency indication signal and a write preamble signal, and generate a control signal, the control signal indicating a first duration for shifting a read modify write command signal; and the shift circuit is configured to shift the read modify write command signal by the first duration according to the control signal, and generate a target command signal, such that a time interval between the target command signal and a write enable signal meets a preset timing condition.

## Description

### CROSS-REFERENCE TO RELATED APPLICATIONS

The present disclosure claims the priority to Chinese Patent Application No. 202311659153.2, filed with the China National Intellectual Property Administration on November 30, 2023, and entitled "COMMAND TIMING CONTROL CIRCUIT AND MEMORY", the content of which is incorporated herein by reference in its entirety.

### TECHNICAL FIELD

The present disclosure relates to the field of semiconductor technologies, and in particular, relates to a command timing control circuit and a memory.

### BACKGROUND

When writing data into memories such as Dynamic Random Access Memory (DRAM), since the Error Checking and Correcting (ECC) operation requires a specific number of bits (e.g., 128 bits) for calculation, if the number of bits of write data is less than the specific number of bits, it is necessary to read data from the memory to make up to the specific number of bits before writing. This results in a read modify write (RMW) operation.

During an RMW operation, after receiving an externally input write command, a read command needs to be generated at an appropriate time for a read operation, such that sufficient time is left for an intermediate operation (such as ECC) from the read command to the write command. How to select the timing for generating the read command is a problem that needs to be solved when performing the RMW operation.

### SUMMARY

Embodiments of the present disclosure provide a command timing control circuit and a memory.

In a first aspect, the embodiments of the present disclosure provide a command timing control circuit. The command timing control circuit includes a decoding circuit and a shift circuit, where:

the decoding circuit is configured to receive a frequency indication signal and a write preamble signal, perform decoding processing according to the frequency indication signal and the write preamble signal, and generate a control signal, the control signal indicating a first duration for shifting a read modify write command signal;

the shift circuit is configured to receive the control signal and the read modify write command signal, shift the read modify write command signal by the first duration according to the control signal, and generate a target command signal, such that a time interval between the target command signal and a write enable signal meets a preset timing condition.

In a second aspect, the embodiments of the present disclosure provide a memory. The memory includes at least the command timing control circuit according to the first aspect.

The embodiments of the present disclosure provide a command timing control circuit and a memory. The command timing control circuit includes a decoding circuit and a shift circuit, where the decoding circuit is configured to receive a frequency indication signal and a write preamble signal, perform decoding processing according to the frequency indication signal and the write preamble signal, and generate a control signal, the control signal indicating a first duration for shifting a read modify write command signal; and the shift circuit is configured to receive the control signal and the read modify write command signal, shift the read modify write command signal by the first duration according to the control signal, and generate a target command signal, such that a time interval between the target command signal and a write enable signal meets a preset timing condition. In this way, the read modify write command signal is shifted to obtain the target command signal according to the control signal obtained by decoding the frequency indication signal and the write preamble signal, such that the shifted read modify write command signal meets the timing requirements, the read modify write command signal can be generated at an appropriate time, and each step of read modify write operation can be performed smoothly.

### BRIEF DESCRIPTION OF THE DRAWINGS

FIG. 1 is a timing diagram 1 of a write operation in DDR5;
FIG. 2 is a timing diagram 2 of a write operation in DDR5;
FIG. 3 is a timing diagram of an RMW command signal under different frequencies;
FIG. 4 is a timing diagram of different write preamble modes;
FIG. 5 is a schematic diagram of a composition structure of a command timing control circuit according to an embodiment of the present disclosure;
FIG. 6 is a schematic diagram of a composition structure of a shift circuit according to an embodiment of the present disclosure;
FIG. 7 is a schematic diagram 1 of a composition structure of a shift sub-circuit according to an embodiment of the present disclosure;
FIG. 8 is a schematic diagram 2 of a composition structure of a shift sub-circuit according to an embodiment of the present disclosure;
FIG. 9 is a schematic diagram 3 of a composition structure of a shift sub-circuit according to an embodiment of the present disclosure;
FIG. 10 is a schematic diagram 4 of a composition structure of a shift sub-circuit according to an embodiment of the present disclosure;
FIG. 11 is a schematic diagram of a composition structure of a decoding circuit according to an embodiment of the present disclosure;
FIG. 12 is a timing diagram of an RMW command signal under different frequencies according to an embodiment of the present disclosure; and
FIG. 13 is a schematic diagram of a composition structure of a memory according to an embodiment of the present disclosure.

### DETAILED DESCRIPTION

The technical solutions in the embodiments of the present disclosure will be described clearly and comprehensively hereinafter in combination with the accompanying drawings in the embodiments of the present disclosure. It can be understood that the specific embodiments described herein are only intended to explain the related application and are not meant to limit the present disclosure. It should be further noted that for the convenience of description, only the portions relevant to the related application are illustrated in the accompanying drawings.

Unless otherwise defined, all technical and scientific terms used herein have the same meaning as commonly understood by those skilled in the art to which the present disclosure belongs. The terms used herein are only for the purpose of describing the embodiments of the present disclosure and are not intended to limit the present disclosure.

In the following description, the term "some embodiments" refers to a subset of all possible embodiments. However, it can be understood that "some embodiments" may refer to the same or different subsets of all possible embodiments and may be combined with each other without conflict.

It should be pointed out that the terms "first/second/third" referred to in the embodiments of the present disclosure are only used for distinguishing similar objects and do not represent a specific order for the objects. Understandably, "first/second/third" may be interchanged in a specific order or sequence if permitted, such that the embodiments of the present disclosure described herein can be implemented in an order other than that shown or described herein.

Before further detailed description of the embodiments of the present disclosure, the nouns and terms referred to in the embodiments of the present disclosure are explained, and the nouns and terms referred to in the embodiments of the present disclosure are applicable to the following explanations:
Static Random Access Memory (SRAM);
Dynamic Random Access Memory (DRAM);
Synchronous Dynamic Random Access Memory (SDRAM);
Double Data Rate SDRAM (DDR SDRAM);
Double Data Rate (DDR);
Double Data Rate 4 (DDR4);
Double Data Rate 5 (DDR5);
Command (CMD);
Data (DQ);
Write (WR);
Read (RD);
Nanosecond (ns);
Read Modify Write (RMW);
Write Column Select (WCSL);
Data Strobe (DQS);
Preamble (PRE);
Write Preamble (WPRE);
Column Address Strobe (CAS);
CAS Write Latency (CWL);
Command/Address (CA);
Bank (BK);
Bank Group (BG);
Error Checking and Correcting (ECC);
Burst Length (BL);
Operand (OP);
Million Times per second (MT/s);
Megabits per second (Mbps);
Picosecond (ps);
Data Flip-Flop or Delay Flip-Flop (DFF);
Positive Channel Metal Oxide Semiconductor Field Effect Transistor/P-type transistor (PMOS transistor);
Negative Channel Metal Oxide Semiconductor Field Effect Transistor/N-type transistor (NMOS transistor).

Taking DDR5 DRAM as an example, when performing write operations, an ECC operation requires a specific number of bits for calculation. Illustratively, 128 bits of data are required to perform 8-bit error correction; when the write data is less than 128 bits, data needs to be read from the memory array through a read command signal to make up to 128 bits of data, the 128 bits of data are modified by the write data, and then the modified 128 bits of data are rewritten into the memory array through the write command signal (i.e., a rewrite operation).

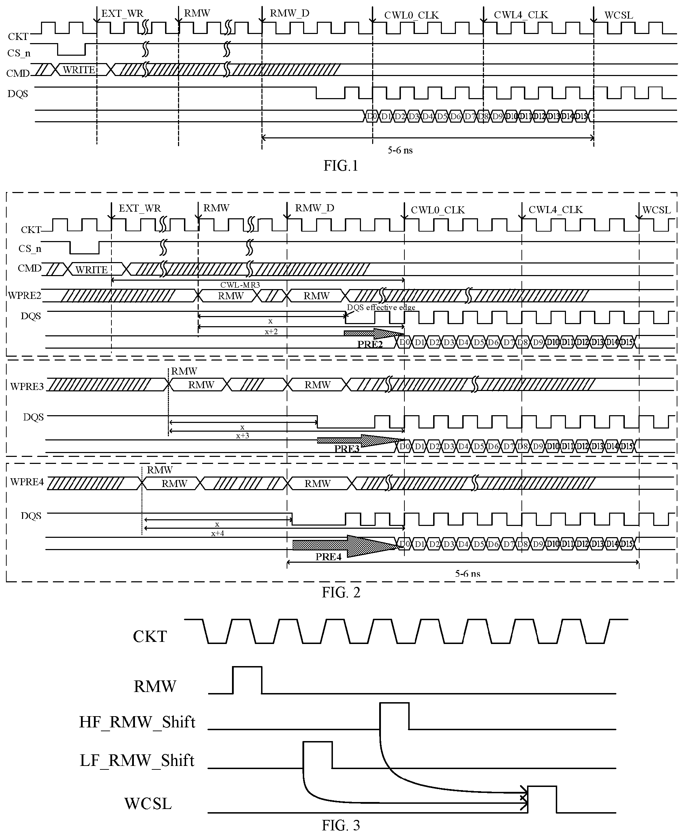

Referring to FIG. 1, FIG. 1 illustrates a timing diagram 1 of a write operation in DDR5. As shown in FIG. 1, the write command signal generated after command decoding (CMD_DEC) (i.e., EXT_WR command signal in FIG. 1) will be shifted by a CWL duration (CWL Shift). During the CWL, the earliest available shifted write command signal is taken as the RMW command signal. After the memory receives the internal read command signal (i.e., RMW_D command signal in FIG. 1), it is necessary to latch information such as CA, BG, and BK and maintain it for a certain time (e.g. 5-6 ns), so as to provide sufficient time for ECC decoding and correction of the data read from the memory array, and merging and re-encoding of the write data and the read data. Then, the latched information is passed through to perform a write operation when the write command (i.e., WCSL signal in FIG. 1) is effective. That is, ECC needs to be read and written between a read operation and a write operation, and thus from the RMW command signal to the WCSL signal, the obtained RMW command signal needs to be released at an appropriate position. In FIG. 1, the appropriate position refers to the position 5-6 ns before the WCSL signal, that is, the position where the RMW_D command signal is located. The RMW_D command signal is a signal obtained by shifting the RMW command signal, a read operation is started at the RMW_D command signal, and a write operation is started at the WCSL signal.

As shown in FIG. 1, the time delay from the EXT_WR command signal to the first bit of input data (i.e., D0) is CWL; for DDR5 DRAM, the CWL may be CWL-MR3, where MR3 represents different values that may be specifically set according to a mode register; after the clock signal CKT samples the EXT_WR command signal, the write operation of the data is started after shifting by CWL. In addition, the WCSL signal is used to turn on a column signal to write data, and information such as CA, BG, and BK needs to be kept in the WCSL signal to write data.

It should be noted that FIG. 1 shows the case where BL is 16, and the DQ terminal transmits 16 pieces of data (D0 to D15) at once. The length of the clock signal CKT when transmitting data is 8T, and in this case, the clock cycle of the clock signal CKT is T. With CWL0_CLK as the origin of time, the CWL4_CLK passes through 4T and the WCSL signal passes through 8T. In FIG. 1, CWL0_CLK is also the origin of coordinates, and the write preamble signal will affect the distance of the RMW command signal relative to CWL0_CLK, i.e. affect the coordinate value of the RMW command signal.

On the basis of FIG. 1, referring to FIG. 2, FIG. 2 illustrates a timing diagram 2 of a write operation in DDR5, specifically, a timing diagram under different write preamble signals. Illustratively, as shown in FIG. 2, the write preamble signal includes three write preambles, which are WPRE2, WPRE3, and WPRE4, respectively. WPRE2, WPRE3, and WPRE4 start receiving or writing data after the DQS effective edge has passed 2T, 3T, and 4T, respectively. That is, there is a 1T difference between WPRE2 and WPRE3, and a 1T difference between WPRE3 and WPRE4. In addition, the duration from the RMW command signal to the DQS effective edge is X, and because all signals follow the same path and to obtain the RMW command signal as early as possible, CWL is fixed and X is also fixed under different write preambles. Since X is fixed and the write preambles are different, this results in the RMW command signal having different coordinate values relative to the origin of coordinates (CWL0_CLK).

Based on the above background, the first shifted write command signal obtained after the write command signal is shifted is determined as the RMW command signal, and the RMW command signal needs to latch information such as CA, BG, and BK and maintain it for a certain time, and then pass the information on when the WCSL signal is valid. However, the RMW command signal is significantly distant from the WCSL signal, and its timing cannot meet the requirements, that is, the distance from the RMW command signal to the WCSL signal does not meet the requirements of 5-6 ns, such that there is insufficient time left for intermediate operations (such as ECC) from the read command signal to the write command signal. In addition, under different write preambles, the DQS effective edge starts receiving or writing data after passing through different times respectively, resulting in different latency times required for the RMW command signal.

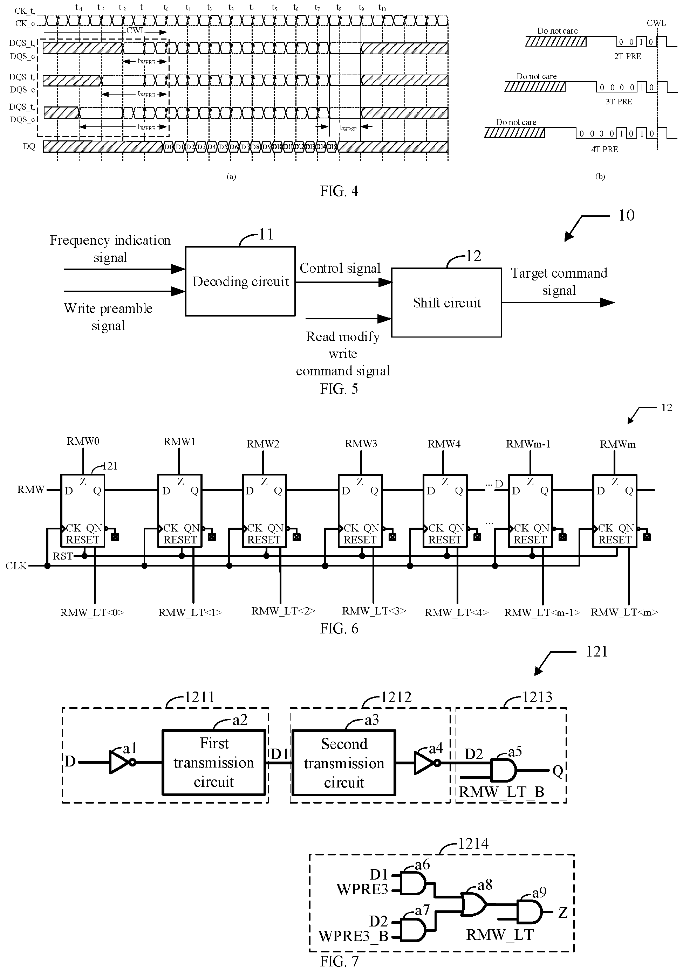

As shown in FIG. 3, HF_RMW_Shift represents the position of the RMW_D command signal at high frequency, LF_RMW_Shift represents the position of the RMW_D command signal at low frequency, and the required shift length, i.e. latency time, of the RMW command signal is different under different frequencies. In addition, as shown in FIG. 4(a), t_{WPRE} represents a write preamble duration, t_{WPST} represents a write postamble duration, and the write preamble and the write postamble are waveform settings for the start and end of the DQS signal; after the write preamble signal changes, the timing relationship between the RMW command signal and the WCSL signal will also change. Specifically, referring to FIG. 4(b), FIG. 4(b) is a partially enlarged view of the write preamble in the dashed box of FIG. 4(a). WPRE2 starts receiving or writing data after the DQS effective edge has passed 2T, represented by 2T PRE; WPRE3 starts receiving or writing data after the DQS effective edge has passed 3T, represented by 3T PRE; and WPRE4 starts receiving or writing data after the DQS effective edge has passed 4T, represented by 4T PRE. As shown in FIG. 4 (a), because the time of the first bit of input data D0 (i.e., the time of t0) is fixed, the position of the DQS effective edge (i.e., the first falling edge) will be different under different write preambles, and the time at which the DQS starts to be effective will be different.

In summary, the timing of the read command signal (i.e. the RMW command signal) directly generated from the write command signal received by the memory cannot meet the requirements, therefore, the read command signal needs to be shifted to adjust the position. However, under different frequency values and different write preambles, the latency time required for the read command signal varies.

Based on this, the embodiments of the present disclosure provide a command timing control circuit. The command timing control circuit includes a decoding circuit and a shift circuit, where the decoding circuit is configured to receive a frequency indication signal and a write preamble signal, perform decoding processing according to the frequency indication signal and the write preamble signal, and generate a control signal, the control signal indicating a first duration for shifting a read modify write command signal; and the shift circuit is configured to receive the control signal and the read modify write command signal, shift the read modify write command signal by the first duration according to the control signal, and generate a target command signal, such that a time interval between the target command signal and a write enable signal meets a preset timing condition. In this way, the read modify write command signal is shifted to obtain the target command signal according to the control signal obtained by decoding the frequency indication signal and the write preamble signal, such that the read operation is performed at the shifted read modify write command signal, information such as CA, BG, and BK is latched and maintained for a certain time, and when the write enable signal is valid, the locked information is passed for write operation. This ensures that the shifted read modify write command signal meets the timing requirements, the read modify write command signal can be generated at an appropriate time under different frequency values and different write preambles, and each step of the read modify write operation can be performed smoothly.

The embodiments of the present disclosure will be described in detail hereinafter in combination with the accompanying drawings.

In an embodiment of the present disclosure, referring to FIG. 5, a schematic diagram of a composition structure of a command timing control circuit according to an embodiment of the present disclosure is illustrated. As shown in FIG. 5, the command timing control circuit 10 may include a decoding circuit 11 and a shift circuit 12.

The decoding circuit 11 is configured to receive a frequency indication signal and a write preamble signal, perform decoding processing according to the frequency indication signal and the write preamble signal, and generate a control signal, the control signal indicating a first duration for shifting a read modify write command signal.

The shift circuit 12 is configured to receive the control signal and the read modify write command signal, shift the read modify write command signal by the first duration according to the control signal, and generate a target command signal, such that a time interval between the target command signal and the write enable signal meets a preset timing condition.

Here, the frequency indication signal is used to indicate the frequency value at which the memory is currently operating, and the write preamble signal is used to indicate the currently set write preamble. The frequency value and the write preamble may be different in different cases. In the present disclosure, the frequency value and the write preamble can be used to control the shift length of the read modify write command signal.

It should be noted that the read modify write command signal is represented by RMW, the target command signal is represented by RMW_D, and the control signal is represented by RMW_LT; the write enable signal may be specifically a write column select signal, represented by WCSL; the preset timing condition is that the time interval between the target command signal and the write enable signal meets the time required for the intermediate operations (such as ECC) during the read operation and the write operation. Illustratively, the time meets 5-6 ns. It can be understood that the target command signal is a shifted RMW command signal, a read operation is started at the target command signal, and a write operation is started at the write enable signal. The read operation and the write operation need to be separated by 5-6 ns to perform operations such as ECC decoding, correction, data merging, and re-encoding on the read data.

In the embodiments of the present disclosure, the command timing control circuit 10 is specifically a related circuit of the RMW command signal in an integrated circuit design and particularly relates to a release circuit of the RMW command signal in a DRAM chip. In addition, the command timing control circuit 10 may be applied to a release circuit of the RMW command signal in a DRAM chip, and may also be applied to other related circuits that release command signals under different frequencies, which is not particularly limited.

As shown in FIG. 5, in the command timing control circuit 10, a control signal is generated by the decoding circuit 11 according to the frequency indication signal and the write preamble signal, and the read modify write command signal is shifted by the shift circuit 12 to generate a target command signal, such that a read operation is performed at the target command signal, and a write operation is performed at the write enable signal. The time interval between the target command signal and the write enable signal meets the preset timing condition, providing sufficient time to perform operations such as ECC decoding, correcting, data merging, and re-encoding on the data read from the memory array, such that the read modify write command signal can be generated at an appropriate time under different frequency values and different write preambles, and each step of the read modify write operation can be performed smoothly.

In some embodiments, the command timing control circuit may further include a command processing circuit.

The command processing circuit is configured to receive a write command signal, perform shift processing on the write command signal to obtain a shifted write command signal, and determine the first shifted write command signal during the column address strobe write latency (CWL) as the read modify write command signal.

It should be noted that CWL is the time delay between an internal write command signal and the first bit of input data (D0), represented by CWL. Specifically, for DDR5, CWL may be CWL-MR3, where MR3 represents a mode register for controlling the write leveling operation, and MR3 stores the variable latency amount. It can be understood that during the CWL, the earliest available shifted write command signal is taken as the read modify write command signal.

Further, in some embodiments, for the shift circuit 12, FIG. 6 illustrates a schematic diagram of a composition structure of a shift circuit according to an embodiment of the present disclosure. As shown in FIG. 6, the shift circuit 12 may include S cascaded and identical shift sub-circuits 121 (only one reference numeral 121 is labeled in FIG. 6, and the rest shift sub-circuits are not labeled); the control signal includes S control sub-signals, and only one of the S control sub-signals is in an enabled state, where S is an integer greater than 1; the input terminal of the first shift sub-circuit 121 is configured to receive the read modify write command signal, the first output terminal of the i-th shift sub-circuit 121 is connected to the input terminal of the (i+1)-th shift sub-circuit 121, and the control terminal of the i-th shift sub-circuit 121 is configured to receive the i-th control sub-signal, where i is an integer greater than 0 and less than S.

The shift circuit 12 is configured to shift the read modify write command signal by the first duration through the first to the j-th shift sub-circuits 121 when the j-th control sub-signal is in an enabled state, to obtain a target command signal, and output the target command signal through the j-th shift sub-circuit 121, where j is an integer greater than 0 and smaller than S.

Here, only one of the S control sub-signals is in an enabled state, so only one bit of the output signal of the shift sub-circuit 121 is valid, and the output signal of the shift sub-circuit 121 corresponding to the control sub-signal in an enabled state is valid.

It should be noted that in the embodiments of the present disclosure, for the shift sub-circuit 121, a clock terminal (CK), an input terminal (D), a first output terminal (Q), a second output terminal (Z), an inverted output terminal (QN), and a reset terminal (RESET) may be included; in addition, a set terminal (SET) and the like may further be included, although these are not shown in the figure. The first output terminal of the i-th shift sub-circuit 121, as an output terminal output to the next stage, is connected to the input terminal of the next shift sub-circuit 121; the second output terminal of the i-th shift sub-circuit 121, as an output terminal of the shift amount, is configured to output the output signal of the corresponding shift sub-circuit 121.

As shown in FIG. 6, the control sub-signal is represented by RMW_LT, the m-th control sub-signal is represented by RMW_LT<m>, and the output signal of the corresponding shift sub-circuit 121 is represented by RMWm (where m is an integer greater than 0 and less than or S). The RMW command signal selects an appropriate shift length under the control of the control sub-signal; the output signals from all the shift sub-circuits 121 have only one valid bit, which is output as a target command signal after logical synthesis. That is, the shift circuit 12 is composed of shift sub-circuits 121 which can control the shift length of the RMW command signal. This allows the read operation at the shifted RMW command signal to proceed smoothly, achieving the normal function of the target command signal.

In some embodiments, as shown in FIG. 6, a clock terminal of each shift sub-circuit 121 is configured to receive a clock signal, and the shift sub-circuit 121 shifts the signal received at the input terminal based on the clock signal.

When i is equal to 1, the first shift sub-circuit 121 shifts the read modify write command signal by two clock cycles or one clock cycle.

When i is greater than 1, the first to (i-1)-th shift sub-circuits 121 shift the signal received at the input terminal by 2 clock cycles, and the i-th shift sub-circuit 121 shifts the signal received at the input terminal by two clock cycles or one clock cycle.

The clock cycle is a cycle of the clock signal.

It should be noted that the clock signal is represented by CLK, and the clock cycle is represented by T.

It should be further noted that the signal received at the input terminal is shifted according to the control sub-signal; when the first control sub-signal is in an enabled state, the first duration is 1T or 2T; when the j-th control sub-signal is in an enabled state, the first duration is [2×(j-1)+1]T or [2×(j-1)+2]T.

In some embodiments, for the shift sub-circuit 121, FIG. 7 illustrates a schematic diagram 1 of a composition structure of a shift sub-circuit according to an embodiment of the present disclosure. As shown in FIG. 7, the i-th shift sub-circuit 121 may include a first output circuit 1211, a second output circuit 1212, a control circuit 1213, and a select circuit 1214.

The first output circuit 1211 is configured to shift the signal received at the input terminal by 1 clock cycle and generate a first shift amount signal. When i is equal to 1, the input terminal of the first output circuit 1211 receives the read modify write command signal, and when i is greater than 1, the input terminal of the first output circuit 1211 receives the signal output by the (i-1)-th shift sub-circuit.

The second output circuit 1212 is configured to receive the first shift amount signal, shift the first shift amount signal by 1 clock cycle, and generate a second shift amount signal.

The control circuit 1213 is configured to receive the second shift amount signal and a control sub-signal and control whether to output the second shift amount signal to the (i+1)-th shift sub-circuit 121 according to the control sub-signal.

The select circuit 1214 is configured to receive the first shift amount signal, the second shift amount signal, the control sub-signal, and a preset write preamble and select to output the first shift amount signal or the second shift amount signal as a target command signal according to the preset write preamble when the control sub-signal is in an enabled state. The preset write preamble instructs the i-th shift sub-circuit 121 to shift the signal received at the input terminal by two clock cycles or one clock cycle.

It should be noted that the first shift amount signal is represented by D1, and the second shift amount signal is represented by D2; the write preamble signal may include WPRE2, WPRE3, and WPRE4, and the preset write preamble is WPRE3. WPRE2, WPRE3, and WPRE4 start receiving or writing data after the DQS effective edge has passed 2T, 3T, and 4T, respectively. One shift sub-circuit 121 can shift the signal received at the input terminal by 2T at most. Shifting by 2T and 4T requires an even number of shift sub-circuits 121, and shifting by 3T requires (k+0.5) shift sub-circuits 121 (where k is a positive integer). Therefore, WPRE3 is used as a preset write preamble, such that when the control sub-signals corresponding to WPRE3 and WPRE4 are the same, by determining whether it is WPRE3 or WPRE4, WPRE3 is selected to be output from the first shift amount signal D1, or WPRE4 is selected to be output from the second shift amount signal D2. This allows the last stage of the shift sub-circuit 121 to shift the signal received at the input terminal by 1T or 2T.

Specifically, when WPRE3 is 1, the current shift sub-circuit 121 outputs the first shift amount signal D1; when WPRE3 is 0, the current shift sub-circuit 121 outputs the second shift amount signal D2. The logic "1" represents a high-level state, and the logic "0" represents a low-level state.

Further, in some embodiments, as shown in FIG. 7, the first output circuit 1211 includes a first NOT gate a1 and a first transmission circuit a2, the second output circuit 1212 includes a second transmission circuit a3 and a second NOT gate a4, the control circuit 1213 includes a first AND gate a5, and the select circuit 1214 includes a second AND gate a6, a third AND gate a7, a first OR gate a8, and a fourth AND gate a9.

The input terminal of the first NOT gate a1 is used as the input terminal of the shift sub-circuit 121; the output terminal of the first NOT gate a1 is connected to the input terminal of the first transmission circuit a2; the output terminal of the first transmission circuit a2 is connected to the input terminal of the second transmission circuit a3 and is configured to output the first shift amount signal.

The output terminal of the second transmission circuit a3 is connected to the input terminal of the second NOT gate a4; the output terminal of the second NOT gate a4 is connected to the first input terminal of the first AND gate a5 and is configured to output the second shift amount signal.

The second input terminal of the first AND gate a5 is configured to receive the inverted control sub-signal, and the output terminal of the first AND gate a5 is used as the first output terminal of the shift sub-circuit.

The first input terminal of the second AND gate a6 is configured to receive the first shift amount signal, the second input terminal of the second AND gate a6 is configured to receive the preset write preamble, and the output terminal of the second AND gate a6 is connected to the first input terminal of the first OR gate a8; the first input terminal of the third AND gate a7 is configured to receive the second shift amount signal, the second input terminal of the third AND gate a7 is configured to receive the inverted preset write preamble, and the output terminal of the third AND gate a7 is connected to the second input terminal of the first OR gate a8; the output terminal of the first OR gate a8 is connected to the first input terminal of the fourth AND gate a9, the second input terminal of the fourth AND gate a9 is configured to receive the control sub-signal, and the output terminal of the fourth AND gate a9 is used as the second output terminal of the shift sub-circuit.

The inverted preset write preamble is obtained by performing inverted processing on the preset write preamble, and the inverted control sub-signal is obtained by performing inverted processing on the control sub-signal.

It should be noted that the second input terminal of the second AND gate a6 may also be configured to receive the delayed preset write preamble, and the second input terminal of the fourth AND gate a9 may also be configured to receive the delayed control sub-signal, which is not particularly limited. The delayed preset write preamble is obtained by performing delayed processing on the preset write preamble, and the delayed control sub-signal is obtained by performing delayed processing on the control sub-signal. Here, the delayed control sub-signal is represented by RMW_LT_T, the inverted control sub-signal is represented by RMW_LT_B, the delayed preset write preamble is represented by WPRE3_T, and the inverted preset write preamble is represented by WPRE3_B.

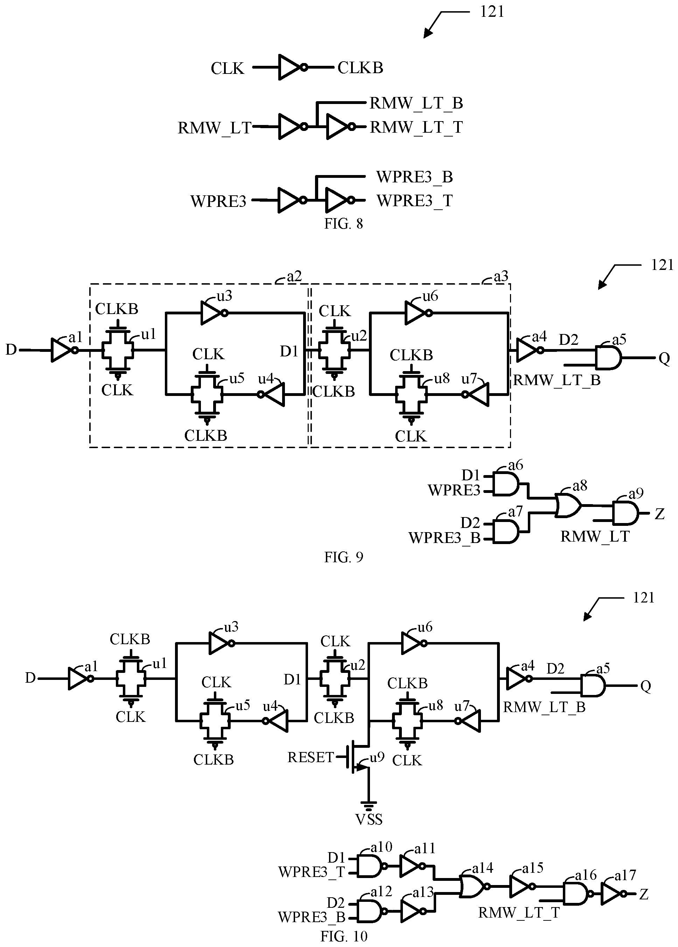

It should be noted that the control sub-signal passes through an odd number of NOT gates to obtain an inverted control sub-signal, and the level states of the inverted control sub-signal and the control sub-signal are opposite; the control sub-signal passes through an even number of NOT gates to obtain a delayed control sub-signal, and the level states of the delayed control sub-signal and the control sub-signal are the same. It can be understood that an odd number of NOT gates may be composed of one NOT gate, or by connecting three, five, seven, etc., NOT gates in series; and an even number of NOT gates may be composed of two NOT gates, or by connecting four, six, eight, etc., NOT gates in series, which is not particularly limited in the embodiments of the present disclosure. Illustratively, in FIG. 8, taking the control sub-signal RMW_LT passing through one NOT gate to obtain an inverted control sub-signal RMW_LT_B and the control sub-signal RMW_LT passing through two NOT gates to obtain a delayed control sub-signal RMW_LT_T as an example, the specific implementation of the embodiments of the present disclosure will be described in detail.

Similarly, the preset write preamble passes through an odd number of NOT gates to obtain an inverted preset write preamble, and the level states of the inverted preset write preamble and the preset write preamble are opposite; and the preset write preamble passes through an even number of NOT gates to obtain a delayed preset write preamble, and the level states of the delayed preset write preamble and the preset write preamble are the same. Illustratively, in FIG. 8, taking the preset write preamble WPRE3 passing through one NOT gate to obtain an inverted preset write preamble WPRE3_B and the preset write preamble WPRE3 passing through two NOT gates to obtain a delayed preset write preamble WPRE3_T as an example, the specific implementation of the embodiments of the present disclosure will be described in detail.

In addition, as shown in FIG. 8, the clock signal CLK passes through one NOT gate to obtain an inverted clock signal CLKB, and the clock signal CLK may also obtain an inverted clock signal CLKB by using a structure composed of three, five, seven, etc., NOT gates in series, which is not particularly limited.

It can be understood that when WPRE3 is 1, that is, WPRE3_T is 1, the signal received at the input terminal is shifted by half of the shift sub-circuit 121, and the current shift sub-circuit 121 outputs the first shift amount signal D1; when WPRE3 is 0, that is, WPRE3_B is 1, the signal received at the input terminal is shifted by an entire shift sub-circuit 121, and the current shift sub-circuit 121 outputs the second shift amount signal D2.

In an embodiment, based on the shift sub-circuit 121 shown in FIG. 7, FIG. 9 illustrates a schematic diagram of a composition structure of a shift sub-circuit according to an embodiment of the present disclosure. As shown in FIG. 9, the first transmission circuit a2 may include a first transmission gate u1 and a first drive circuit, and the second transmission circuit a3 may include a second transmission gate u2 and a second drive circuit. The first drive circuit may include a third NOT gate u3, a fourth NOT gate u4, and a third transmission gate u5, and the second drive circuit may include a fifth NOT gate u6, a sixth NOT gate u7, and a fourth transmission gate u8.

The output terminal of the first NOT gate a1 is connected with the first terminal of the first transmission gate u1; the input terminal of the third NOT gate u3 and the second terminal of the third transmission gate u5 are both connected with the second terminal of the first transmission gate u1; the output terminal of the third NOT gate u3 and the input terminal of the fourth NOT gate u4 are both connected with the first terminal of the second transmission gate u2; and the output terminal of the fourth NOT gate u4 is connected with the first terminal of the third transmission gate u5;

The input terminal of the fifth NOT gate u6 and the second terminal of the fourth transmission gate u8 are both connected to the second terminal of the second transmission gate u2; the output terminal of the fifth NOT gate u6 and the input terminal of the sixth NOT gate u7 are both connected to the input terminal of the second NOT gate a4; the output terminal of the sixth NOT gate u7 is connected to the first terminal of the fourth transmission gate u8.

It should be noted that the transmission gate is a controllable switch circuit that can transmit both digital signals and analog signals and has bidirectional signal transmission characteristics. The transmission gate is composed of one PMOS transistor and one NMOS transistor in parallel, the gates of the PMOS transistor and the NMOS transistor are used as two control terminals and are respectively connected to a pair of signals that are opposite to each other, the sources of the PMOS transistor and the NMOS transistor are connected to serve as an input terminal, and the drains of the PMOS transistor and the NMOS transistor are connected to serve as an output terminal. Since the drains and sources of the PMOS transistor and the NMOS transistor may be interchanged, the input terminal and the output terminal of the transmission gate may also be interchanged.

As shown in FIG. 9, each transmission gate is composed of one PMOS transistor and one NMOS transistor in parallel, where the gate of the PMOS transistor is configured to receive the clock signal CLK, and the gate of the NMOS transistor is configured to receive the inverted clock signal CLKB. Based on this configuration, clock edge transitions can be achieved. In addition, in the embodiments of the present disclosure, the first terminal is an input terminal, and the second terminal is an output terminal.

In another embodiment, as shown in FIG. 10, the second AND gate a6 is replaced by a first NAND gate a10 and a seventh NOT gate a11, the third AND gate a7 is replaced by a second NAND gate a12 and an eighth NOT gate a13, the first OR gate a8 is replaced by a first NOR gate a14 and a ninth NOT gate a15, and the fourth AND gate a9 is replaced by a third NAND gate a16 and a tenth NOT gate a17. The specific connection relationships are shown in FIG. 10. Here, the second input terminal of the first NAND gate a10 is configured to receive the delayed preset write preamble WPRE3_T, and the second input terminal of the third NAND gate a16 is configured to receive the delayed control sub-signal RMW_LT_T.

In addition, as shown in FIG. 10, the i-th shift sub-circuit 121 may further include a reset transistor u9. The reset transistor u9 is an NMOS transistor, the gate of the reset transistor u9 is configured to receive the reset signal RESET, the source of the reset transistor u9 is configured to receive the ground signal VSS, and the drain of the reset transistor u9 is connected to the input terminal of the fifth NOT gate u6, the second terminal of the fourth transmission gate u8, and the second terminal of the second transmission gate u2. Here, VSS represents a ground signal (may also be referred to as "ground terminal"), which is used to provide a low-level signal (the low level/low-level state in the embodiment both refer to the logic "0").

It can be understood that when the RMW_LT signal is at a high level, the RMW_LT_B signal is at a low level, the output value at the first output terminal Q of the shift sub-circuit 121 is 0, and the RMW command signal does not continue the shift process. Additionally, the RMW_LT_T signal is at a high level and is output from the current shift sub-circuit 121, and the output at the second output terminal Z of the shift sub-circuit 121 is turned on. Based on the write preamble signal, the output port is selected as either D1 point or D2 point to achieve different shift timings for WPRE2, WPRE4, and WPRE3. After the output from the shift sub-circuit 121, all outputs are logically synthesized into a target command signal output, such that the RMW command signal can be accurately released, and the RMW command signal can meet the timing requirements.

In some embodiments, a second duration compensated for shifting the read modify write command signal is obtained through encoding according to the frequency value indicated by the frequency indication signal; and a third duration compensated for shifting the read modify write command signal is obtained through encoding according to the write preamble signal.

The second duration is equal to A times the clock cycle, the third duration is equal to B times the clock cycle, and the first duration is related to the second duration and the third duration; A and B are both greater than 0, and A is less than B.

It should be noted that A and B may be integers, that is, the second duration and the third duration are equal to integer multiples of the clock cycle, which is not particularly limited.

In some embodiments, the first duration is composed of both the second duration and the third duration, e.g., the first duration is an algebraic sum of the second duration and the third duration.

Table 1 illustrates the relevant specifications for OP [3:0] and the data rate for MR13 (mode register 13) in DDR5. As shown in Table 1, the frequency indication signal is OP [3:0] (i.e., a combined notation for OP [3], OP [2], OP [1], and OP [0]). Specifically, the frequency indication signal is MR13_ OP [3:0], and MR13 is a mode register with frequency information. When the values of MR13_OP [3:0] are different, the value range of the data rates is also different. Here, the data rate is the data rate on the data bus and is proportional to the frequency value. When the data rate changes, the frequency value also changes proportionally, such that the frequency value can be indicated by the data rate.

It should be noted that as shown in Table 1, tCCD_L.min, tCCD_L_WR2.min, tCCD_L_WR.min, and tDLLK.min are all time intervals in DRAM that have fixed meanings in the art. When the frequency values are different, the values (nCK) representing the multiples of the unit clock cycle of the time intervals are also different accordingly.

**Table 1**

| Function | OP [3:0] | tCCD L. min(nCK) | tCCD_L_WR2. min(nCK) | tCCD_L_WR. min(nCK) | tDLLK.min (nCK) | Details |
|---|---|---|---|---|---|---|
| tCCD_L/ tCCD_L_ WR/tCCD_L_WR2/tDLLK | 0000 | 8 | 16 | 32 | 1024 | 1980MT/S≤Data Rate ≤2100MT/S & 2933MT/S ≤Data Rate≤3200MT/S |
| | 0001 | 9 | 18 | 36 | 1024 | 3200MT/S≤Data Rate ≤3600MT/S |
| | 0010 | 10 | 20 | 40 | 1280 | 3600MT/S≤Data Rate ≤4000MT/S |
| | 0011 | 11 | 22 | 44 | 1280 | 4000MT/S≤Data Rate ≤4400MT/S |
| | 0100 | 12 | 24 | 48 | 1536 | 4400MT/S≤Data Rate ≤4800MT/S |
| | 0101 | 13 | 26 | 52 | 1536 | 4800MT/S≤Data Rate ≤5200MT/S |
| | 0110 | 14 | 28 | 56 | 1792 | 5200MT/S≤Data Rate ≤5600MT/S |
| | 0111 | 15 | 30 | 60 | 1792 | 5600MT/S≤Data Rate ≤6000MT/S |
| | 1000 | 16 | 32 | 64 | 2048 | 6000MT/S≤Data Rate ≤6400MT/S |
| | 1001 | 17 | 34 | 68 | 2048 | 6400MT/S≤Data Rate ≤6800MT/S |
| | 1010 | 18 | 36 | 72 | 2304 | 6800MT/S≤Data Rate ≤7200MT/S |
| | 1011 | 19 | 38 | 76 | 2304 | 7200MT/S≤Data Rate ≤7600MT/S |
| | 1100 | 20 | 40 | 80 | 2560 | 7600MT/S≤Data Rate ≤8000MT/S |
| | 1101 | 21 | 42 | 84 | 2560 | 8000MT/S≤Data Rate ≤8400MT/S |
| | 1110 | 22 | 44 | 88 | 2816 | 8400MT/S≤Data Rate ≤8800MT/S |
| | 1111 | Reserved | | | | |

In some embodiments, the write preamble signal includes N write preambles, where N is an integer greater than 0; the frequency indication signal includes at least one bit of operand, the at least one bit of operand corresponds to M logic combinations, and each logic combination corresponds to a frequency value, where M is an integer greater than 0.

Table 2 illustrates a coding table according to an embodiment of the present disclosure. As shown in Table 2, the unit of the data rate is consistent with Table 1; TCCD_L represents a longer time interval from CAS command to CAS command, and may specifically be a time interval between CAS commands for the same bank; PREAMBLE2, PREAMBLE3, and PREAMBLE4 are WPRE2, WPRE3, and WPRE4, respectively, and their values are stored in the mode register MR8 and can be read from the mode register MR8; CWLO is the above CWL0_CLK, representing the origin of coordinates.

Illustratively, as shown in Table 2, the write preamble signal includes three write preambles, which are WPRE2, WPRE3, and WPRE4, respectively. The embodiment takes three write preambles as an example, but it is not limited to this. It should be noted that the write preamble is related to the frequency value, and the memory will select the corresponding write preamble under different frequency values according to the command transmitted by a host. When some frequency values correspond to a plurality of write preambles, the host decides which write preamble to select ultimately. The specific waveforms of the write preamble may refer to PRE2, PRE3, and PRE4 in FIG. 2.

In addition, illustratively, as shown in Table 2, the frequency indication signal includes 4-bit operands from MR13_OP0 to MR13_OP3 (i.e., OP0 to OP3), and the frequency indication signal may also be represented by OP [3:0]. The embodiment takes the frequency indication signal including a 4-digit operand as an example, but it is not limited to this.

**Table 2**

| OP [3:0] | Data Rata | TCCD _L | CWLO | WCSL | RMW _D | PREAMBLE2 | | PREAMBLE3 | | PREAMBLE4 | |
|---|---|---|---|---|---|---|---|---|---|---|---|
| | | | | | | RMW | Code | RMW | Code | RMW | Code |
| 0000 | ≤3200 | 8 | 0 | 8 | -2 | X | [X+2] | X-1 | [X-2+2] | X-2 | [X-2+2] |
| 0001 | ≤3600 | 9 | 0 | 8 | -2 | X | [X+2] | X-1 | [X-2+2] | X-2 | [X-2+2] |
| 0010 | ≤4000 | 10 | 0 | 8 | -4 | X | [X+4] | X-1 | [X-2+4\| | X-2 | [X-2+4\| |
| 0011 | ≤4400 | 11 | 0 | 8 | -4 | X | [X+4] | X-1 | [X-2+4\| | X-2 | [X-2+4\| |
| 0100 | ≤4800 | 12 | 0 | 8 | -6 | X | [X+6] | X-1 | [X-2+6] | X-2 | [X-2+6] |
| 0101 | ≤5200 | 13 | 0 | 8 | -6 | X | [X+6] | X-1 | [X-2+6] | X-2 | [X-2+6] |
| 0110 | ≤5600 | 14 | 0 | 8 | -8 | X | [X+8] | X-1 | [X-2+8\| | X-2 | [X-2+8\| |
| 0111 | ≤6000 | 15 | 0 | 8 | -8 | X | [X+8] | X-1 | [X-2+8\| | X-2 | [X-2+8\| |
| 1000 | ≤6400 | 16 | 0 | 8 | -8 | X | [X+8] | X-1 | [X-2+8\| | X-2 | [X-2+8\| |

It should be noted that in Table 2, X represents the start point of the RMW command signal without considering the compensation amount for the frequency value and the write preamble. The start point is the rising edge of the RMW command signal, and the pulse length of the RMW command signal is 2T. Since CWLO is the origin of coordinates, it can be seen from FIG. 2 that X is a negative value. Since there is a 1T difference between WPRE2 and WPRE3 and a 1T difference between WPRE3 and WPRE4, and the earliest position of the RMW command signal under WPRE2 is at X, when compensating for the time difference caused by the write preamble, the earliest position of the RMW command signal under WPRE3 is at X-1, and the earliest position of the RMW command signal under WPRE4 is at X-2. It can be understood that the second duration and the third duration compensate for the originally same shift amount X under different frequency values and different write preambles.

It should be noted that the values -2, -4, -6, and -8 for the RMW_D command signal are obtained through calculation, and the purpose is to ensure that the time interval between the RMW_D command signal and the WCSL signal meets the preset timing condition of 5-6 ns under different frequency values. Therefore, the RMW_D command signal is subject to a corresponding negative offset based on the frequency value. Illustratively, when the frequency value is 3200 Mbps, 1T is about 625 ps, and 5-6 ns is approximately equal to 10T. Since the data DQ output occupies 8T, the offset of the RMW_D command signal under the frequency value is 2T. In addition, since -2, -4, -6, -8, etc., are all even numbers, the command timing control circuit 10 may be made simpler. Additionally, as shown in Table 2, 3200 MT/s and 3600 MT/s have the same code value, such that the area of the command timing control circuit 10 can be saved.

It should be noted that the code value represents the shift length from the RMW command signal to the RMW_D command signal. Here, the code value of WPRE3 is written to match the code value of WPRE4, keeping both consistent. Since the 1T difference between WPRE3 and WPRE4 will output at the same stage of the shift sub-circuit, specifically at the first shift amount signal D1 point and the second shift amount signal D2 point of the same stage of the shift sub-circuit, respectively, WPRE3 is used as a preset write preamble to distinguish the release positions of WPRE3 and WPRE4 at the same code value. Illustratively, according to Table 2, when the frequency value is 3200 MT/s, the value of the RMW command signal under WPRE2 is -10, then the value of the RMW command signal under WPRE3 is -11, and the value of the RMW command signal under WPRE4 is -12; the value of RMW command signal to RMW_D command signal under WPRE2 is 8, the value of RMW command signal to RMW_D command signal under WPRE3 is 9, and the value of RMW command signal to RMW_D command signal under WPRE4 is 10. One shift sub-circuit can shift the signal received at the input terminal by 2T at most, that is, under WPRE2, the signal received at the input terminal needs to be shifted by four shift sub-circuits; under WPRE3 and WPRE4, the signal received at the input terminal needs to be shifted by five shift sub-circuits. However, at the fifth shift sub-circuit, it is necessary to determine whether to output from the D1 point under WPRE3 or from the D2 point under WPRE4, achieving the 1T or 2T movement in the final stage of the shift sub-circuit.

In summary, to enable the RMW command signal to the WCSL signal to meet the timing requirements under different frequency values and different write preambles, the shift length of the RMW command signal needs to be encoded and controlled, and the code information with different frequencies is encoded according to the MR13 mode register. Assuming that CWLO is CLK0 (origin of time), the WCSL signal passes through 8T, corresponding to CLK8. Since there are 5-6 ns from the RMW command signal to the WCSL signal, the release position of the RMW command signal is obtained by counting back 5-6 ns from the WCSL signal according to different frequency values. Assuming that under WPRE2, after the write command signal is shifted during the CWL period, the earliest possible time position for the RMW command signal is X, and the shift length is the duration from the RMW command signal to the RMW_D command signal, according to the specification, the earliest positions of the RMW command signal under WPRE3 and WPRE4 are X-1 and X-2, respectively. As shown in Table 2, the same set of code values is used under WPRE3 and WPRE4. An additional process is performed in the shift sub-circuit according to the write preamble signal, and in the cases of WPRE3 and WPRE4 relative to WPRE2, the code values are increased by 2.

In the prior art, the frequency range is divided into only the low-frequency band, the intermediate-frequency band, and the high-frequency band. The frequency range is narrowed in the embodiments of the present disclosure, and the frequency range is more precise relative to the prior art. Specifically, as shown in Table 2, based on the variation of TCCD_L, the frequency values are precisely divided into nine frequency bands, ranging from ≤ 3200 MT/s to ≤ 6400 MT/s, with each frequency band having an interval of 400 MT/s. In addition, if circuits are developed to operate at higher frequencies in the future, such as 6800 MT/s, 7200 MT/s, etc., the corresponding code value may be realized by continuing to add coding according to the coding logic, and the application range is wider compared with the prior art. Additionally, in the present disclosure, the control signal transmitted by the TCCD_L controller is encoded to achieve the output of RMW command signals at different positions, which is beneficial for DRAM to be aware of the operating frequency of the chip in real-time, ensuring the working timing of the chip under different frequencies and improving stability.

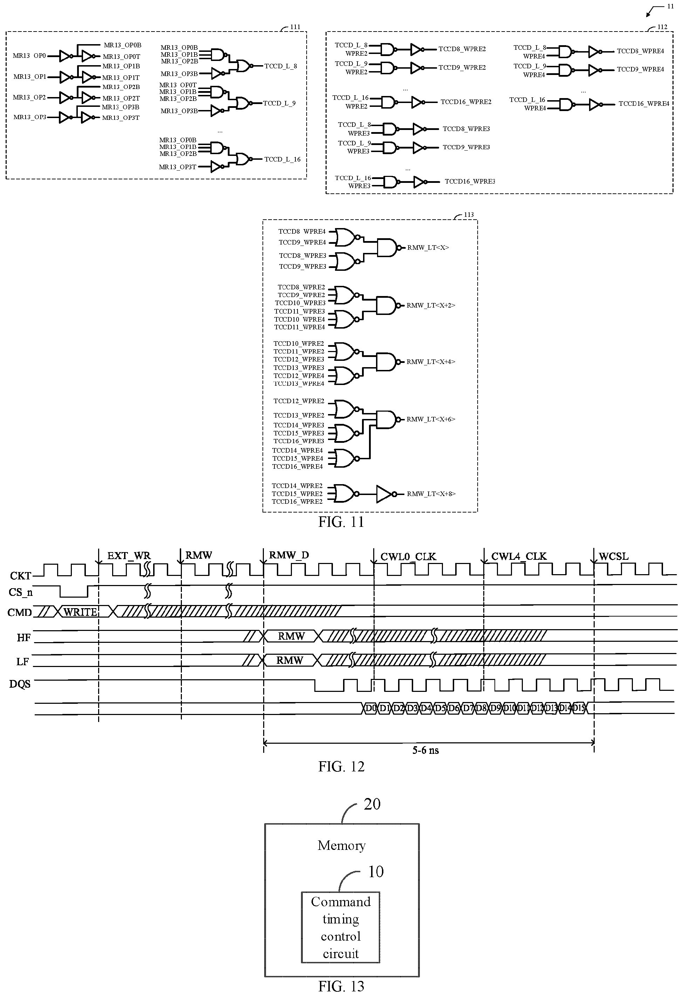

According to Table 2, the control signal may be obtained by the decoding circuit 11. In some embodiments, for the decoding circuit 11, FIG. 11 illustrates a schematic diagram of a composition structure of a decoding circuit according to an embodiment of the present disclosure. As shown in FIG. 11, the decoding circuit 11 may include a first decoding circuit 111, a second decoding circuit 112, and a third decoding circuit 113.

The first decoding circuit 111 is configured to receive at least one bit of operand, perform first logic processing according to the at least one bit of operand, and generate M frequency code signals, where the M frequency code signals are in a one-to-one correspondence with M frequency values, and only one of the M frequency code signals is in an enabled state.

The second decoding circuit 112 is configured to receive the M frequency code signals and N write preambles, perform AND logic processing on each frequency code signal and each write preamble, and generate M×N initial control sub-signals.

The third decoding circuit 113 is configured to receive M×N initial control sub-signals, perform OR logic processing on several of the M×N initial control sub-signals, respectively, and generate S control sub-signals.

Illustratively, as shown in FIG. 11, the first decoding circuit 111 includes a 4-bit operand consisting of MR13_OP0, MR13_OP1, MR13_OP2, and MR13_OP3. MR13_OP0 passes through a NOT gate to obtain MR13_OP0B, where the level state of MR13_OP0B is opposite to the level state of MR13_OP0; MR13_OP0 passes through two NOT gates to obtain MR13_OP0T, where the level state of MR13_OP0T is the same as the level state of MR13_OP0. Similarly, MR13_OP1 passes through a NOT gate to obtain MR13_OP1B, where the level state of MR13_OP1B is opposite to the level state of MR13_OP1; MR13_OP1 passes through two NOT gates to obtain MR13_OP1T, where the level state of MR13_OP1T is the same as the level state of MR13_OP1. MR13_OP2 passes through a NOT gate to obtain MR13_OP2B, where the level state of MR13_OP2B is opposite to the level state of MR13_OP2; MR13_OP2 passes through two NOT gates to obtain MR13_OP2T, where the level state of MR13_OP2T is the same as the level state of MR13_OP2. MR13_OP3 passes through a NOT gate to obtain MR13_OP3B, where the level state of MR13_OP3B is opposite to the level state of MR13_OP3; MR13_OP3 passes through two NOT gates to obtain MR13_OP3T, where the level state of MR13_OP3T is the same as the level state of MR13_OP3.

Here, MR13_OP0B represents that the 0th bit of the operand is 0, and MR13_OP0T represents that the 0th bit of the operand is 1. Similarly, MR13_OP1B represents that the first bit of the operand is 0, and MR13_OP1T represents that the first bit of the operand is 1; MR13_OP2B represents that the second bit of the operand is 0, and MR13_OP2T represents that the second bit of the operand is 1; MR13_OP3B represents that the third bit of the operand is 0, and MR13_OP3T represents that the third bit of the operand is 1.

It should be noted that an operand passing through an odd number of NOT gates results in an inverted operand with a level state opposite to that of the operand, and an opcode passing through an even number of NOT gates results in a delayed operand with a level state the same as that of the operand. It can be understood that an odd number of NOT gates may be composed of one NOT gate, or by connecting three, five, seven, etc., NOT gates in series; and an even number of NOT gates may be composed of two NOT gates, or by connecting four, six, eight, etc., NOT gates in series, which is not particularly limited in the embodiments of the present disclosure. Illustratively, in FIG. 11, taking the operand passing through a NOT gate to obtain an inverted operand and the operand passing through two NOT gates to obtain a delayed operand as an example, the specific implementation of the embodiments of the present disclosure will be described in detail.

As shown in FIG. 11, there are nine frequency code signals, namely TCCD_L_8, TCCD_L_9, TCCD_L_10, ..., and TCCD_L_16. According to Table 2, the frequency code signals correspond to the values of MR13_OP [3:0] as 0000, 0001, 0010, ..., and 1000, respectively. The nine frequency code signals correspond to nine values of MR13_OP [3:0] as well as nine frequency values, respectively.

It should also be noted that the value of MR13_OP[3:0] in Table 2 is used to determine whether to input an inverted operand or a delayed operand in the first decoding circuit 111 to obtain the frequency code signal. Illustratively, as shown in FIG. 11, the value of MR13_OP [3:0] corresponding to TCCD_L_9 is 0001, so the frequency code signal TCCD_L_9 is obtained by inputting MR13_OP0T, MR13_OP1B, MR13_OP2B, and MR13_OP3B. In addition, as shown in FIG. 11, in the first decoding circuit 111, a three-input NAND gate is input with MR13_OP0T, MR13_OP1B, and MR13_OP2B, respectively, and a NOT gate is input with MR13_OP3B. Since the fourth bit of operand MR13_OP3 is used less frequently, it is handled separately and not included in the calculation. However, it is also possible to use two two-input NAND gates for inputting MR13_OP0T, MR13_OP1B, MR13_0P2B, and MR13_OP3B, which is not particularly limited.

As shown in FIG. 11, the second decoding circuit 112 includes nine frequency code signals TCCD_L_8, TCCD_L_9, TCCD_L_10, ..., and TCCD_L_16 as well as three write preambles WPRE2, WPRE3, and WPRE4. Therefore, there are twenty-seven initial control sub-signals in total, which are TCCD8_WPRE2, ..., TCCD16_WPRE2, TCCD8_WPRE3, ..., TCCD16 _WPRE3, TCCD8_WPRE4, ..., and TCCD16_WPRE4, respectively. Illustratively, as shown in FIG. 11, for the frequency code signal TCCD_L_8 and the write preamble WPRE2, the initial control sub-signal TCCD8_WPRE2 is obtained through one NAND gate and one NOT gate, and the initial control sub-signal TCCD8_WPRE2 may also be obtained through one AND gate, which is not particularly limited.

As shown in FIG. 11, in the third decoding circuit 113, five control sub-signals are obtained by twenty-seven initial control sub-signals, and only one of the five control sub-signals is in a high-level state, i.e., in an enabled state, to control the above shift circuit 12, thus determining which stage of the shift sub-circuit 121 the target command signal is outputted from.

It should be noted that the third decoding circuit 113 corresponds to Table 2. It can be understood that because WPRE3 and WPRE4 have the same coding, the presence of WPRE3 in the input of the third decoding circuit 113 indicates the presence of WPRE4. Then, a preset write preamble in the shift sub-circuit is used to make the selection.

Illustratively, as shown in FIG. 11, taking the first sub-circuit in the third decoding circuit 113 as an example, in Table 2, when TCCD_L is 8 and 9, the shift amounts, i.e., the code values, under WPRE3 and WPRE4 are X-2+2=X. Therefore, the initial control sub-signals input to the first sub-circuit in the third decoding circuit 113 are TCCD8 _WPRE4, TCCD9_WPRE4, TCCD8 _WPRE3, and TCCD9_WPRE3, respectively, and the output control sub-signal is RMW_LT<X>.

In addition, taking the second sub-circuit in the third decoding circuit 113 as an example, the control sub-signal is RMW_LT<X+2>, and the shift amount is X+2. As shown in Table 2, when TCCD_L is 8 and 9, the shift amount under WPRE2 is X+2, and when TCCD_L is 10 and 11, the shift amount under WPRE3 and WPRE4 is X-2+4=X+2. Therefore, the initial control sub-signals input to the second sub-circuit in the third decoding circuit 113 are TCCD8_WPRE2, TCCD9_WPRE2, TCCD10_WPRE3, TCCD11_WPRE3, TCCD10_ WPRE4, and TCCD11_WPRE4, respectively, and the output control sub-signal is RMW_LT<X+2>.

That is, the decoding circuit 11 decodes MR13_OP[3:0] into a code containing the frequency information (i.e., frequency code signal), combines the write preamble and the code containing the frequency information through AND logic processing to generate initial control sub-signals, and finally encodes the code to which the write preamble information is added (i.e., the initial control sub-signals) into control sub-signals RMW_LT<X> to RMW_LT<X+8> according to Table 2.

Based on the above command timing control circuit 10, FIG. 12 illustrates a timing diagram of an RMW command signal under different frequencies according to an embodiment of the present disclosure, specifically, a schematic diagram illustrating the correct release of the RMW command signal under different frequencies. As shown in FIG. 12, in both high-frequency and low-frequency situations, the first RMW command signal obtained after the shift during the CWL period is shifted to the start point of the RMW command signal (i.e. the point where the target command signal RMW_D is located) after the encoding control. In this case, the timing relationship between the shifted RMW command signal and the WCSL signal meets 5-6 ns, meeting the timing requirements.

In another embodiment of the present disclosure, FIG. 13 illustrates a schematic diagram of a composition structure of a memory according to an embodiment of the present disclosure. As shown in FIG. 13, the memory 20 may include the command timing control circuit 10 according to any one of the above embodiments.

The memory 20 may be an SRAM, a DRAM, an SDRAM, a DDR SDRAM, and the like, which is not particularly limited.

Further, in some embodiments, the memory 20 may include a DRAM chip. The DRAM chip may comply with not only the memory specifications such as DDR, DDR2, DDR3, DDR4, DDR5, and DDR6, but also the memory specifications such as LPDDR, LPDDR2, LPDDR3, LPDDR4, LPDDR5, and LPDDR6, which is not particularly limited.

In the embodiments of the present disclosure, for the memory 20, the read modify write command signal is shifted to obtain a target command signal according to the control signal obtained by decoding the frequency indication signal and the write preamble signal, such that the time interval between the target command signal and the write enable signal meets a preset timing condition. As a result, the read modify write command signal can be generated at an appropriate time under different frequency values and different write preambles, and each step of the read modify write operation can be performed smoothly.

For details not disclosed in the embodiments of the present disclosure, reference may be made to the descriptions of the above embodiments for understanding.

The above descriptions are merely preferred embodiments of the present disclosure and are not intended to limit the protection scope of the present disclosure.

It should be noted that in the present disclosure, the terms "include", "comprise", or any other variants thereof are intended to cover a non-exclusive inclusion. Thus, a process, method, item, or apparatus including a series of elements includes not only those elements but also other elements not explicitly listed, or elements inherent to such process, method, item, or device. Without further limitation, an element defined by the phrase "including a ..." does not exclude the presence of additional identical elements in the process, method, item, or apparatus that includes the element.

The serial numbers of the embodiments of the present disclosure above are only for the purpose of description and do not represent the superiority or inferiority of the embodiments.

The methods disclosed in the several method embodiments according to the present disclosure may be combined arbitrarily if without conflict to obtain new method embodiments.

The features disclosed in the several product embodiments according to the present disclosure may be combined arbitrarily if without conflict to obtain new product embodiments.

The features disclosed in the several method or device embodiments according to the present disclosure may be combined arbitrarily if without conflict to obtain new method embodiments or device embodiments.

The above descriptions are merely specific embodiments of the present disclosure, but the protection scope of the present disclosure is not limited thereto. Changes or substitutions that any one skilled in the art can easily think of within the technical scope disclosed by the present disclosure shall all fall within the protection scope of the present disclosure. Therefore, the protection scope of the present disclosure shall be subject to the protection scope of the claims.

## Claims

1. A command timing control circuit (10), comprising a decoding circuit (11) and a shift circuit (12), wherein:
the decoding circuit (11) is configured to receive a frequency indication signal and a write preamble signal, perform decoding processing according to the frequency indication signal and the write preamble signal, and generate a control signal (RMW_LT), the control signal indicating a first duration for shifting a read modify write command signal (RMW); and
the shift circuit (12) is configured to receive the control signal and the read modify write command signal, shift the read modify write command signal by the first duration according to the control signal, and generate a target command signal (RMW_D), such that a time interval between the target command signal and a write enable signal (WCSL) meets a preset timing condition.

2. The command timing control circuit according to claim 1, wherein the shift circuit comprises S cascaded shift sub-circuits (121), the control signal comprises S control sub-signals, and only one of the S control sub-signals is in an enabled state, wherein S is an integer greater than 1; an input terminal of a first shift sub-circuit of the S shift sub-circuits is configured to receive the read modify write command signal, a first output terminal of an i-th shift sub-circuit of the S shift sub-circuits is connected to an input terminal of an (i+1)-th shift sub-circuit of the S shift sub-circuits, and a control terminal of the i-th shift sub-circuit of the S shift sub-circuits is configured to receive an i-th control sub-signal of the S control sub-signals, wherein i is an integer greater than 0 and less than S; and wherein:
the shift circuit is configured to shift the read modify write command signal by the first duration through the first to a j-th shift sub-circuits of the S shift sub-circuits when a j-th control sub-signal of the S control sub-signals is in an enabled state, to obtain the target command signal, and output the target command signal through the j-th shift sub-circuit of the S shift sub-circuits, wherein j is an integer greater than 0 and smaller than S.

3. The command timing control circuit according to claim 2, wherein a clock terminal (CK) of each one of the S shift sub-circuits (121) is configured to receive a clock signal, and each one of the S shift sub-circuits shifts a signal received at an input terminal based on the clock signal, wherein:
when i is equal to 1, a first shift sub-circuit of the S shift sub-circuits shifts the read modify write command signal by two clock cycles or one of the two clock cycles; and
when i is greater than 1, the first to an (i-1)-th shift sub-circuits of the S shift sub-circuits shift signals received at input terminals by the two clock cycles, and the i-th shift sub-circuit of the S shift sub-circuits shifts a signal received at an input terminal by the two clock cycles or one of the two clock cycles,
wherein the clock cycle is a cycle of the clock signal.

4. The command timing control circuit according to any one of claims 1-3, wherein a second duration compensated for shifting the read modify write command signal is obtained through encoding according to a frequency value indicated by the frequency indication signal; and a third duration compensated for shifting the read modify write command signal is obtained through encoding according to the write preamble signal,
wherein the second duration is equal to A times the clock cycle, the third duration is equal to B times the clock cycle, and the first duration is related to the second duration and the third duration; A and B are both greater than 0, and A is less than B.

5. The command timing control circuit according to claim 2 or 3, wherein the write preamble signal comprises N write preambles, wherein N is an integer greater than 0; the frequency indication signal comprises at least one bit of operand, wherein the at least one bit of operand corresponds to M logic combinations, and each one of the M logic combinations corresponds to a frequency value, with M being an integer greater than 0; and the decoding circuit (11) comprises a first decoding circuit (111), a second decoding circuit (112), and a third decoding circuit (113), wherein:
the first decoding circuit (111) is configured to receive the at least one bit of operand, perform first logic processing according to the at least one bit of operand, and generate M frequency code signals, with the M frequency code signals in a one-to-one correspondence with M of the frequency values, and only one of the M frequency code signals being in an enabled state;
the second decoding circuit (112) is configured to receive the M frequency code signals and the N write preambles, perform AND logic processing on each one of the M frequency code signals and each one of the N write preambles, and generate M×N initial control sub-signals; and
the third decoding circuit (113) is configured to receive the M×N initial control sub-signals, perform OR logic processing on several of the M×N initial control sub-signals, respectively, and generate the S control sub-signals.

6. The command timing control circuit according to claim 3, wherein the i-th shift sub-circuit (121) of the S shift sub-circuits comprises a first output circuit (1211), a second output circuit (1212), a control circuit (1213), and a select circuit (1214), wherein:
the first output circuit (1211) is configured to shift the signal received at the input terminal by one clock cycle, and generate a first shift amount signal (D1), wherein when i is equal to 1, an input terminal of the first output circuit receives the read modify write command signal, and when i is greater than 1, the input terminal of the first output circuit receives a signal output by the (i-1)-th shift sub-circuit of the S shift sub-circuits;
the second output circuit (1212) is configured to receive the first shift amount signal, shift the first shift amount signal by one clock cycle, and generate a second shift amount signal (D2);
the control circuit (1213) is configured to receive the second shift amount signal and the control sub-signal, and control whether to output the second shift amount signal to the (i+1)-th shift sub-circuit of the S shift sub-circuits according to the control sub-signal; and
the select circuit (1214) is configured to receive the first shift amount signal, the second shift amount signal, the control sub-signal, and a preset write preamble, and select to output the first shift amount signal or the second shift amount signal as the target command signal according to the preset write preamble when the control sub-signal is in an enabled state; the preset write preamble instructs the i-th shift sub-circuit of the S shift sub-circuits to shift the signal received at the input terminal by two clock cycles or one of the two clock cycles.

7. The command timing control circuit according to claim 6, wherein the first output circuit (1211) comprises a first NOT gate (a1) and a first transmission circuit (a2), the second output circuit comprises a second transmission circuit (a3) and a second NOT gate (a4), the control circuit comprises a first AND gate (a5), and the select circuit comprises a second AND gate (a6), a third AND gate (a7), a first OR gate (a8), and a fourth AND gate (a9), wherein:
an input terminal of the first NOT gate (a1) is used as an input terminal of the shift sub-circuit (121); an output terminal of the first NOT gate (a1) is connected to an input terminal of the first transmission circuit (a2); and an output terminal of the first transmission circuit (a2) is connected to an input terminal of the second transmission circuit (a3) and is configured to output the first shift amount signal;
an output terminal of the second transmission circuit (a3) is connected to an input terminal of the second NOT gate (a4); and an output terminal of the second NOT gate (a4) is connected to a first input terminal of the first AND gate (a5) and is configured to output the second shift amount signal;
a second input terminal of the first AND gate (a5) is configured to receive an inverted control sub-signal, and an output terminal of the first AND gate (a5) is used as a first output terminal of the shift sub-circuit (121);
a first input terminal of the second AND gate (a6) is configured to receive the first shift amount signal, a second input terminal of the second AND gate (a6) is configured to receive the preset write preamble, and an output terminal of the second AND gate (a6) is connected to a first input terminal of the first OR gate (a8); a first input terminal of the third AND gate (a7) is configured to receive the second shift amount signal, a second input terminal of the third AND gate (a7) is configured to receive an inverted preset write preamble, and an output terminal of the third AND gate (a7) is connected to a second input terminal of the first OR gate (a8); an output terminal of the first OR gate (a8) is connected to a first input terminal of the fourth AND gate (a9), a second input terminal of the fourth AND gate (a9) is configured to receive the control sub-signal, and an output terminal of the fourth AND gate (a9) is used as a second output terminal of the shift sub-circuit,
wherein, the inverted preset write preamble is obtained by performing inverted processing on the preset write preamble, and the inverted control sub-signal is obtained by performing inverted processing on the control sub-signal.

8. The command timing control circuit according to claim 7, wherein the first transmission circuit (a2) comprises a first transmission gate (u1) and a first drive circuit, the second transmission circuit (a3) comprises a second transmission gate (u2) and a second drive circuit, the first drive circuit comprises a third NOT gate (u3), a fourth NOT gate (u4), and a third transmission gate (u5), and the second drive circuit comprises a fifth NOT gate (u6), a sixth NOT gate (u7), and a fourth transmission gate (u8), wherein:
the output terminal of the first NOT gate (a1) is connected to a first terminal of the first transmission gate (u1); an input terminal of the third NOT gate (u3) and a second terminal of the third transmission gate (u5) are both connected to a second terminal of the first transmission gate (u1); an output terminal of the third NOT gate (u3) and an input terminal of the fourth NOT gate (u4) are both connected to a first terminal of the second transmission gate (u2); and an output terminal of the fourth NOT gate (u4) is connected to a first terminal of the third transmission gate (u5); and
an input terminal of the fifth NOT gate (u6) and a second terminal of the fourth transmission gate (u8) are both connected to a second terminal of the second transmission gate (u2); an output terminal of the fifth NOT gate (u6) and an input terminal of the sixth NOT gate (u7) are both connected to the input terminal of the second NOT gate (a4); and an output terminal of the sixth NOT gate (u7) is connected to a first terminal of the fourth transmission gate (u8).

9. The command timing control circuit according to any one of claims 1 to 8, further comprising a command processing circuit, wherein:
the command processing circuit is configured to receive a write command signal, perform shift processing on the write command signal to obtain a shifted write command signal, and determine a first shifted write command signal during a column address strobe write latency period as the read modify write command signal.

10. A memory (20), comprising the command timing control circuit (10) according to any one of claims 1 to 9.
